Europäisches Patentamt

European Patent Office

Office européen des brevets

(19)

(11) Numéro de publication: **0 208 602**
**B1**

# (12) FASCICULE DE BREVET EUROPEEN

(45) Date de publication du fascicule du brevet:
**19.12.90**

(21) Numéro de dépôt: **86401431.1**

(22) Date de dépôt: **27.06.86**

(51) Int. Cl.⁵: **H03K 5/26,** H03K 23/54,
G01R 23/10, G06F 7/62

(54) Procédé d'utilisation d'un registre binaire à N cellules bistables permettant de déterminer le rapport de deux fréquences et dispositif pour la mise en oeuvre du procédé.

(30) Priorité: **03.07.85 FR 8510173**

(43) Date de publication de la demande:
**14.01.87 Bulletin 87/3**

(45) Mention de la délivrance du brevet:
**19.12.90 Bulletin 90/51**

(84) Etats contractants désignés:
**DE GB IT NL**

(56) Documents cités:
**FR-A- 1 343 995**
**FR-A- 2 075 867**
**US-A- 3 056 044**
**US-A- 3 971 994**

(73) Titulaire: **COMMISSARIAT A L'ENERGIE ATOMIQUE**
**Etablissement de Caractère Scientifique Technique et**
**Industriel, 31/33, rue de la Fédération, F-75015 Paris(FR)**

(72) Inventeur: **Dupoy, Marc, 21, rue des Morillons,**
**F-75015 Paris(FR)**

(74) Mandataire: **Mongrédien, André et al, c/o**
**BREVATOME 25, rue de Ponthieu, F-75008 Paris(FR)**

## Description

La présente invention concerne un procédé d'utilisation d'un registre binaire à n cellules bistables permettant de déterminer le rapport de deux fréquences et un dispositif pour la mise en oeuvre de ce procédé.

L'invention s'applique en particulier à la détermination du rapport de deux fréquences de signaux périodiques, ou aléatoires comme dans le cas d'événements nucléaires.

Un registre binaire à n cellules bistables utilisé dans le procédé de l'invention est connu de l'homme de l'art. Un tel registre est par exemple commercialisé sous la référence 74197. Ce type de registre fonctionne généralement soit en compteur binaire, soit en registre à décalage.

Un registre binaire à n cellules bistables, caractérisé également de registre binaire à n bistables, comprend n bistables connectés entre eux. Chaque bistable $B_i$, avec i entier tel que $1 \le i \le n$, possède deux états stables : un état activé que l'on représente par l'élément binaire 1 et un état non activé que l'on représente par l'élément binaire 0. L'état d'un bistable dépend des signaux d'entrées qui lui sont appliqués. Un bistable $B_i$ représente donc quand il est activé le nombre $2^{(i-1)}$ en numération décimale. Tout nombre entier peut s'écrire sous la forme d'une somme de puissances entières de 2. Les coefficients multiplicatifs de ces puissances de deux représentent par juxtaposition ce nombre entier en numération binaire. L'état des différents bistables d'un registre binaire représente donc le contenu du registre en numération binaire.

Ainsi, lorsque les bistables $B_5$ et $B_3$ d'un registre binaire à cinq bistables sont activés, les autres bistables étant à l'état 0, le contenu du registre est égal en numération binaire à 10100, c'est-à-dire en numération décimale à
$1.2^4 + 0.2^3 + 1.2^2 + 0.2^1 + 0.2^0 = 20$.

Ainsi, en fonctionnement en compteur binaire, on envoie sur une entrée comptage d'un registre binaire à n bistables à partir du premier bistable $B_1$ composant celui-ci, un signal d'entrée $S_1$ sous forme d'un train d'impulsions. A chaque impulsion du signal $S_1$, le contenu du registre est incrémenté d'une unité. Ainsi, lorsque le bistable d'entrée $B_1$ est à l'état 0, il est activé par une impulsion du signal $S_1$ et passe à l'état 1. En revanche, lorsque le bistable $B_1$ est à l'état 1, il passe à l'état 0 et incrémente le bistable $B_2$ suivant. Le bistable $B_2$ passe à l'état 1 si son état précédent était 0 ou passe à l'état 0 si son état précédent était 1 en incrémentant le bistable $B_3$ et ainsi de suite.

On peut donc déduire de l'état des n bistables le contenu du registre c'est-à-dire le nombre d'impulsions reçu en entrée du registre en numération binaire, le bistable $B_1$ représentant le bistable de poids le plus faible et le bistable $B_n$, le bistable de poids le plus fort.

Un registre binaire à n cellules bistables peut bien entendu fonctionner en décompteur par décrément du contenu du registre d'une unité, à chaque impulsion du signal $S_1$.

En fonctionnement en registre à décalage, on envoie sur une entrée décalage du registre à n bistables, un signal d'entrée $S_2$ sous forme d'un train d'impulsions. Ce signal $S_2$ est appliqué simultanément sur tous les bistables. A chaque impulsion du signal $S_2$, le contenu du registre est décalé d'un bistable, du bistable $B_n$ vers le bistable $B_1$ avec introduction d'un état 0 dans le bistable $B_n$ ; ceci revient donc à diviser le contenu du registre par deux. Si, à chaque impulsion du signal $S_2$, le contenu du registre est décalé d'un bistable, du bistable $B_1$ vers le bistable $B_n$ avec introduction d'un état 0 dans le bistable $B_1$ ; ceci revient alors à multiplier par deux le contenu du registre. On peut également faire de même, en travaillant sur le contenu du registre en complément de deux et en introduisant un état 1 à la place d'un état 0.

La présente invention a justement pour objet un procédé d'utilisation d'un registre binaire à n cellules bistables de manière à ce qu'il fonctionne simultanément en compteur binaire et en registre à décalage.

De façon plus précise l'invention concerne un procédé d'utilisation d'un registre binaire à n cellules bistables connectées entre elles, avec une entrée décalage, pour déterminer le rapport de deux fréquences F1 et F2, caractérisé en ce qu'on envoie sur une entrée comptage un premier signal impulsionnel $S_1$ de fréquence $F_1$ et sur l'entrée décalage un deuxième signal impulsionnel $S_2$ de fréquence $F_2$, avec $F_1 >> F_2$, le contenu du registre étant en permanence incrémenté d'une unité à chaque impulsion du premier signal $S_1$ et décalé de façon à diviser par deux le contenu du registre à chaque impulsion du deuxième signal $S_2$, le contenu dudit registre étant représentatif du rapport des deux fréquences.

Selon un mode d'utilisation du registre binaire à n cellules bistables on charge le contenu dudit registre dans un registre tampon à n cellules connecté audit registre binaire à n cellules bistables, à chaque impulsion du deuxième signal $S_2$.

Selon un autre mode d'utilisation du registre binaire à n cellules bistables, on mesure une fréquence inconnue en envoyant en entrée dudit registre un signal de fréquence de référence et le signal de fréquence inconnue, le contenu du registre permettant de déterminer la fréquence inconnue à partir de la fréquence de référence.

Selon un autre mode d'utilisation du registre binaire à n cellules bistables, on affiche le logarithme en base deux du contenu dudit registre par l'intermédiaire de dispositifs d'affichage connectés audit registre, chaque bistable activé $B_i$ représentant le nombre $2^{(i-1)}$ en numération décimale, avec i entier tel que $1 \le i \le n$.

Selon un autre mode d'utilisation du registre binaire à n cellules bistables, pour la détection du passage de ce rapport à une valeur donnée, l'impulsion de détection correspond à l'activation de la cellule bistable matérialisant ladite valeur.

L'invention a également pour objet un dispositif pour la mise en oeuvre du procédé d'utilisation comprenant :

- un registre binaire à n cellules bistables ;
- des dispositifs d'affichage pour afficher le logarithme en base deux du contenu dudit registre, lesdits dispositifs étant connectés d'une part aux sorties du registre binaire à n cellules bistables et d'autre part à un niveau de tension commun à l'ensemble de ces dispositifs, chaque dispositif d'affichage comprenant une porte logique OU connectée en sortie à une cellule d'affichage, la sortie d'une porte logique OU d'un dispositif d'affichage étant connectée à l'entrée de la porte logique OU du dispositif d'affichage de poids inférieur.

Selon un mode de réalisation du dispositif, la cellule d'affichage est une diode photo-émissive.

Selon une variante de réalisation du dispositif, la cellule d'affichage est une cellule à cristal liquide.

Selon un autre mode de réalisation du dispositif, chaque dispositif d'affichage est connecté à une seule cellule bistable à la fois.

Selon une autre variante de réalisation du dispositif, les cellules d'affichage sont remplacées par un générateur de courant ou de tension connecté à un dispositif de représentation analogique d'une valeur proportionnelle au logarithme du contenu du registre, par l'intermédiaire d'un circuit sommateur.

Selon une variante de réalisation, les dispositifs d'affichage comprennent en outre $2^p - 1$ dispositifs d'affichage intermédiaires permettant d'avoir une précision de $1/(2^p)$ sur l'affichage, ces dispositifs d'affichage intermédiaires étant disposés entre un dispositif d'affichage associé à une cellule bistable $B_i$ et un dispositif d'affichage associé à une cellule bistable $B_{i+1}$, avec i et p entiers tels que $1 \leq i \leq n$ et $p \leq 1$, les dispositifs d'affichage intermédiaires commandés par des dispositifs logiques réalisant des sommes des contenus des cellules bistables $B_i$, $B_{i-1}$, ..., $B_{i-p}$. Par exemple, p dispositifs d'affichage intermédiaires sont connectés respectivement par l'intermédiaire d'une porte logique ET d'une part à une des p cellules bistables $B_{i-1}$...$B_{i-p}$ de poids inférieur à la cellule bistable $B_i$ et d'autre part à la cellule bistable $B_i$ et les dispositifs d'affichage intermédiaires restants sont connectés respectivement, par l'intermédiaire d'une porte logique ET, à la sortie des portes logiques ET de deux des dispositifs d'affichage intermédiaires.

Selon un autre mode de réalisation du dispositif celui-ci comprend un registre tampon à n cellules, chaque cellule étant connectée à la sortie d'une seule cellule bistable.

D'autres caractéristiques et avantages ressortiront mieux de la description qui va suivre donnée en référence aux figures annexées dans lesquelles :

- la figure 1a représente schématiquement un registre à n cellules bistables utilisé selon le procédé de l'invention,
- la figure 1b représente un chronogramme d'exemple de signaux d'entrée appliqués à un registre à quatre bistables utilisé selon le procédé de l'invention ainsi que l'état résultant de ces bistables transféré sur un registre tampon,
- la figure 2a représente schématiquement un exemple d'application du registre binaire à n cellules bistables utilisé selon le procédé conforme à l'invention permettant d'afficher le logarithme en base deux du contenu dudit registre,
- La figure 2b représente schématiquement un exemple d'application permettant d'améliorer la précision de l'affichage de l'exemple d'application de la figure 2a.

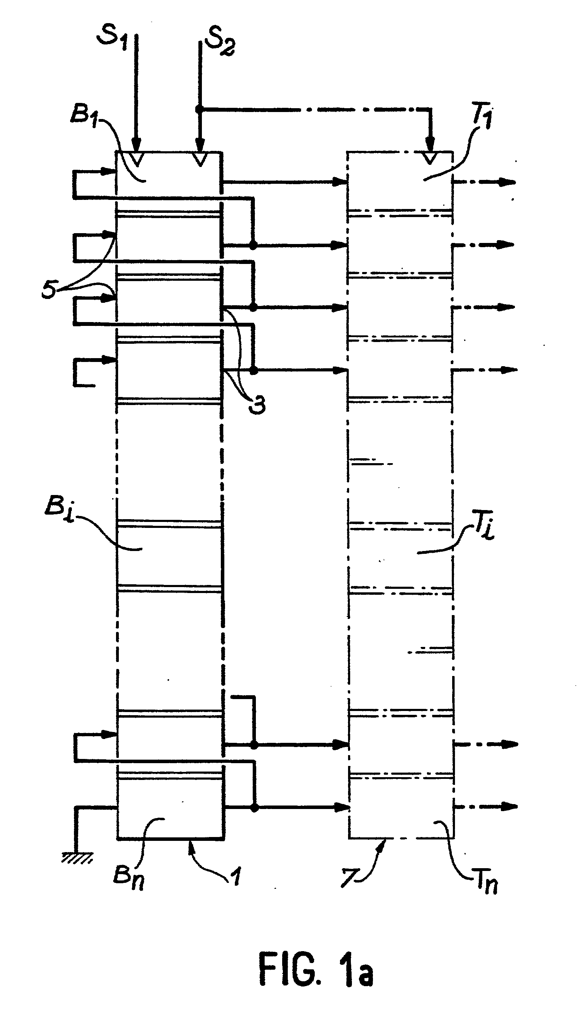

La figure 1a représente schématiquement un registre binaire 1 à n cellules bistables utilisé selon le procédé de l'invention.

Les n bistables ou cellules bistables composant ce registre sont connectées entre elles, la sortie 3 de chaque bistable $B_i$ étant connectée à l'entrée 5 du bistable $B_{i-1}$, avec i entier tel que $1 \leq i \leq n$. Le bistable $B_1$ de rang 1 représente le bistable de poids le plus faible, correspondant quand il est activé au nombre entier 2° et le bistable $B_n$ de rang n représente le bistable de poids le plus fort, correspondant quand il est activé au nombre entier $2^{n-1}$.

En entrée du registre binaire 1 et à partir du bistable $B_1$ on envoie deux signaux $S_1$ et $S_2$ se présentant sous la forme de trains d'impulsions périodiques ou aléatoires de fréquences respectivement $F_1$ et $F_2$, avec $F_1 \gg F_2$.

Le signal $S_1$ correspondant à la fréquence $F_1$ est envoyé sur une entrée de comptage du registre binaire 1 et le signal $S_2$ de fréquence $F_2$ est envoyé sur une entrée décalage de ce registre 1.

Le contenu du registre binaire 1, représenté par l'état des différents bistables du registre 1 est incrémenté en permanence à chaque impulsion du signal $S_1$ de fréquence $F_1$ et divisé par deux lorsque le registre 1 reçoit une impulsion du signal $S_2$ de fréquence $F_2$. La division par deux se fait comme on l'a vu précédemment par un décalage du contenu du registre d'un bistable, du bistable $B_n$ de poids le plus fort vers le bistable $B_1$ de poids le plus faible, le bistable $B_n$ de poids le plus fort étant mis à l'état 0.

Lorsque l'on prend pour origine des temps $t = 0$ correspondant à la mise en fonctionnement du registre 1, à l'instant $t = 1/F_2$, $1/F_2$ correspondant à la période du signal $S_2$, le registre 1 a reçu $F_1/F_2$ impulsions du signal $S_1$ de fréquence $F_1$ et une impulsion du signal $S_2$ de fréquence $F_2$. Le contenu du registre est alors divisé par deux, il est égal à $F_1/(2.F_2)$. De même à l'instant $t = 2/F_2$, le contenu du registre est égal à $F_1/(2.F_2) + F_1/(4.F_2)$, etc... Le contenu N du registre à l'instant $t = k/F_2$, est donc donné par la relation suivante :

$$N = \frac{F_1}{F_2} \cdot \left( \frac{1}{2^1} + \frac{1}{2^2} + \ldots \frac{1}{2^k} \right)$$

La quantité entre parenthèses est approximativement égale à $1 - (1/2^k)$ qui tend vers 1 lorsque k augmente indéfiniment. Le contenu N du registre tend donc après chaque impulsion du signal $S_2$ vers une valeur limite égale à $F_1/F_2$, représentant le rapport des deux fréquences des signaux d'entrée $S_1$ et $S_2$. Entre l'instant $t = k/F_2$ et l'instant

$$t = (\frac{k+1}{F_2}) - \varepsilon,$$

avec $\varepsilon \ll 1/F_2$, le contenu du registre oscille donc entre les valeurs N et 2N, c'est-à-dire entre $F_1/F_2$ et $2.F_1/F_2$.

Comme tout nombre positif peut s'exprimer sous la forme d'une puissance x de deux, x étant généralement non entier, le contenu du registre est égal à $2^x$ avec $0 \leq x \leq n-1$ ; x représente donc le logarithme en base deux du contenu du registre. Le rang i du bistable $B_i$ de poids le plus fort activé représente donc par excès le logarithme en base deux du nombre contenu dans le registre 1.

A partir du registre à n cellules bistables utilisé selon le procédé de l'invention, diverses applications sont possibles. L'application principale est la mesure d'une fréquence inconnue $F_i$ à partir d'une fréquence de référence $F_r$, le contenu du registre après ou avant division (N ou 2N) étant représentatif du rapport de ces deux fréquences.

La fréquence de référence $F_r$ peut être aussi bien $F_1$ que $F_2$. Cependant si l'on veut obtenir un temps de réponse inversement proportionnel à la fréquence inconnue $F_i$, on prendra comme fréquence inconnue $F_2$.

Le signal de fréquence $F_r$ peut être notamment un signal d'horloge ou le signal d'un oscillateur ajustable.

Dans le cas où le signal de fréquence $F_i$ est aléatoire comme dans le cas d'événements nucléaires, la fréquence $F_i$ est préalablement divisée par un compteur binaire, ce qui permet un lissage, donc d'éviter des fluctuations de fréquences. En revanche, lorsque le niveau du signal de fréquence $F_i$ varie lentement ou même pas du tout, ce circuit diviseur est facultatif.

Ainsi, si l'on envoie par exemple un signal de fréquence $F_2$ fixe connue sur une entrée décalage du registre 1 et un signal de fréquence $F_1$ inconnue sur une entrée comptage de celui-ci, on pourra déduire la fréquence inconnue $F_1$ à partir du contenu du registre représentant le rapport $F_1/F_2$. Ainsi, si on introduit un signal de fréquence $F_1$ représentant des événements nucléaires et un signal de fréquence $F_2$ égal à 1 Hz, le contenu N du registre représentera le taux de comptage exprimé en coups par seconde.

On peut également utiliser le registre binaire à n cellules bistables conforme à l'invention, en discriminateur de fréquences permettant de comparer une fréquence inconnue à une fréquence de seuil choisie. On définit une fréquence inconnue $F_1$ ou $F_2$ par rapport à une fréquence de seuil et en introduisant une fréquence de référence $F_2$ ou $F_1$, par la relation :

$$\frac{F_1}{2^{i-1}} \geq F_2 \; ;$$

cette relation est établie lorsque le bistable de rang i est activé après division du contenu du registre ou bien lorsque le bistable de rang i+1 est activé avant division, la relation

$$\frac{F_1}{2^{i-1}} < F_2$$

étant établie lorsque le bistable de rang i est à l'état 0 après division ou bien lorsque le bistable de rang i+1 est à l'état 0 avant division. L'impulsion de passage par la fréquence de seuil est donc engendrée par l'activation du bistable de rang i lorsque la lecture se fait après division ou le bistable de rang i+1 lorsque la lecture se fait avant division. La fréquence de seuil est matérialisée de préférence par le bistable de poids le plus élevé ; l'activation de ce bistable engendre l'impulsion de passage par le seuil.

Ainsi, si on envoie sur un registre conforme à l'invention un signal de fréquence $F_2$ fixe et un signal de fréquence $F_1$ inconnue si le bistable matérialisant le seuil de la fréquence choisie est à l'état 0, la fréquence $F_1$ est inférieure à la fréquence de seuil, en revanche s'il est à l'état 1, la fréquence $F_1$ est supérieure ou égale à la fréquence de seuil choisie.

Dans ce cas particulier, le registre binaire à n bistables est utilisé en discriminateur de fréquence.

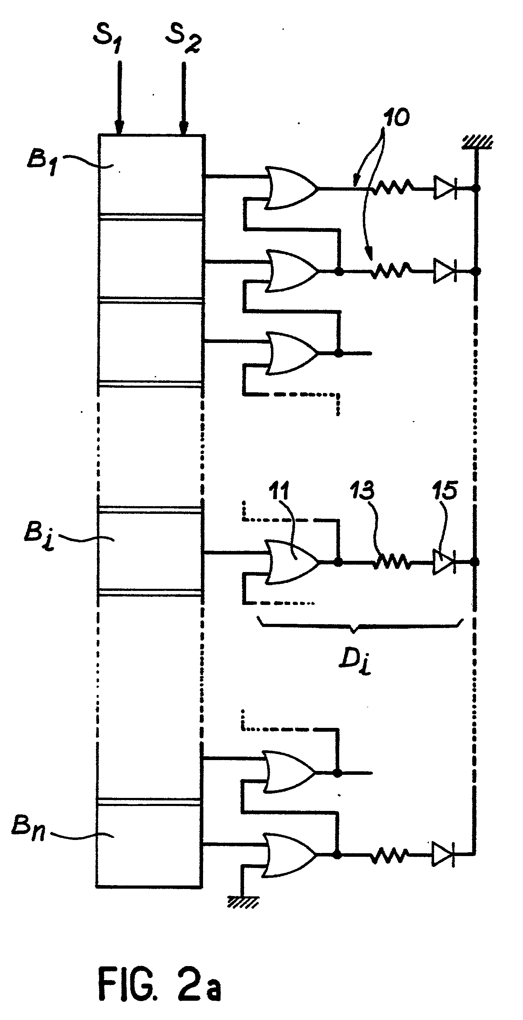

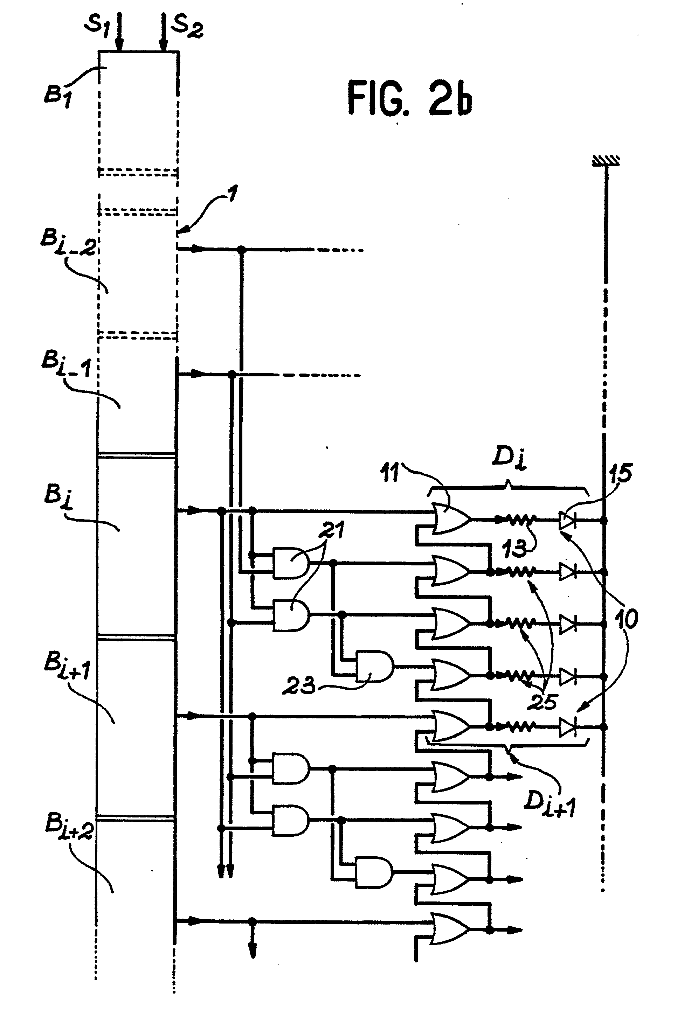

On a vu précédemment, que le rang correspondant au dernier bistable activé représente le logarithme en base deux par excès du contenu du registre, la précision de ce logarithme pouvant être améliorée en tenant compte des bistables de poids inférieurs activés. On peut donc obtenir un affichage analogique du contenu d'un registre binaire à n bistables en associant à ce registre des dispositifs d'affichage. Cet exemple d'application sera décrit plus en détail dans les figures 2a et 2b.

Pour éviter les fluctuations du contenu du registre binaire 1 à n bistables, à chaque impulsion des signaux $S_1$ et $S_2$ de fréquences $F_1$ et $F_2$, on peut associer à ce registre 1 un registre tampon 7 qui charge le contenu du registre 1 à chaque impulsion du signal $S_2$ de fréquence $F_2$. Ce registre tampon 7 comprend n cellules, chaque cellule $T_i$ étant connectée à la sortie d'un bistable $B_i$, avec i entier tel que $1 \leq i \leq n$. Le signal $S_2$ de fréquence $F_2$ est envoyé également à l'entrée du registre tampon, pour qu'à chaque impulsion du signal $S_2$, le contenu de chaque bistable $B_i$, avant ou après division, soit chargé dans la cellule $T_i$ du registre tampon correspondante.

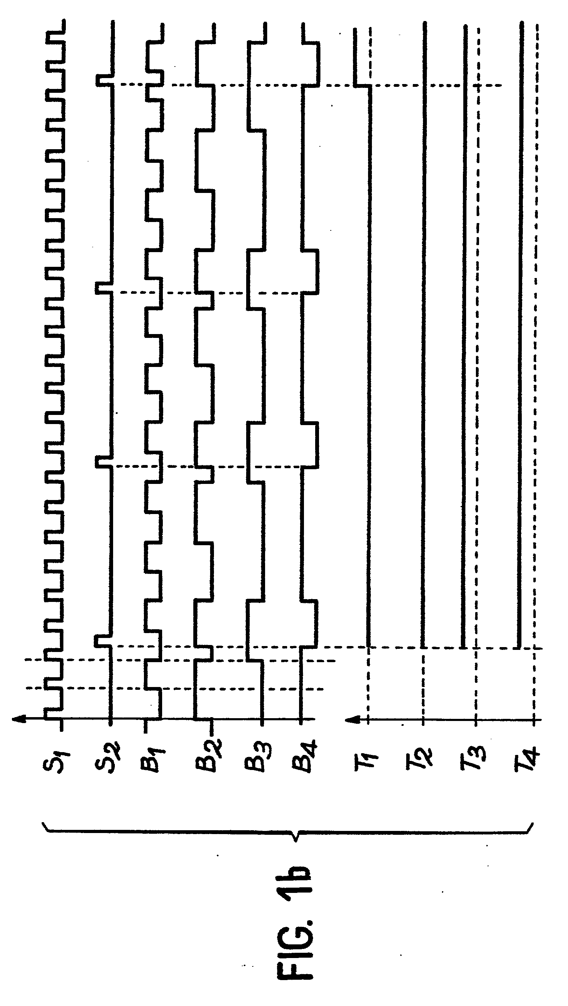

La figure 1b représente un chronogramme d'exemples de signaux appliqués en entrée d'un registre binaire à quatre bistables conforme à l'invention avec les différents états résultant de ces bistables. Ce chronogramme permet de mieux comprendre le fonctionnement d'un registre 1 utilisé selon le procédé de l'invention ainsi que le fonctionnement d'un registre tampon 7 qui lui est éventuellement associé.

Le signal $S_1$ correspondant à la fréquence $F_1$ est envoyé sur une entrée comptage du registre 1 et le signal $S_2$ de fréquence $F_2$ est envoyé sur une entrée décalage du registre 1, avec $F_1 \gg F_2$. Les états des quatre cellules bistables $B_1$, $B_2$, $B_3$, $B_4$ du

registre sont représentés dans l'ordre du bistable B₁ de poids le plus faible correspondant comme on l'a vu précédemment à 2⁰ au bistable B₄ de poids le plus fort correspondant à 2³.

Avant la première impulsion du signal S₁, le contenu du registre en numération binaire représenté par les niveaux activés ou non activés des quatre bistables du registre est 1001. La première impulsion du signal S₁ va incrémenter le contenu du registre d'une unité, le nouveau contenu est alors 1010. A la deuxième impulsion du signal S₁ le contenu de registre prend alors la valeur 1011 et ainsi de suite jusqu'à ce qu'une impulsion du signal S₂ soit appliquée en entrée du registre 1. Avant la première impulsion du signal S₂, le contenu du registre est 1100. L'impulsion du signal F₂ va provoquer un décalage du contenu du registre d'un bistable, du bistable B₄ de poids le plus fort au bistable B₁ de poids le plus faible avec une désactivation du bistable B₄ de poids le plus fort. Le contenu de registre est alors égal à 0110, ce qui équivaut à une division par deux. Ces opérations sont répétées ainsi successivement, le contenu du registre fluctue donc entre la valeur N et 2N entre chaque décalage.

Pour éviter ces fluctuations on peut par exemple associer à un registre à n bistables, fonctionnant de façon conforme à l'invention, un registre tampon classique dans lequel est chargé le contenu du registre avant ou après décalage, à chaque apparition d'une impulsion de signal S₂.

Dans le cas d'un registre à quatre bistables B₁, B₂, B₃, B₄, on lui associe un registre tampon à quatre cellules T₁, T₂, T₃, T₄, chaque cellule Tᵢ étant connectée à la sortie du bistable Bᵢ, avec i entier tel que 1 ≤ i ≤ 4 pour cet exemple.

Les différents états des quatre cellules tampons T₁, T₂, T₃, T₄ associés respectivement aux quatre bistables B₁, B₂, B₃, B₄ sont représentés également sur la figure 1b.

On voit qu'à chaque impulsion du signal S₂, le contenu de chaque bistable Bᵢ est chargé avant décalage dans la cellule Tᵢ correspondante. Ainsi à la première impulsion du signal S₂ le contenu du registre à quatre bistables en numération binaire est 1100. Ce nombre est alors chargé dans le registre tampon qui lui est associé, les cellules T₄, T₃, T₂, T₁ sont alors respectivement dans les états 1100. Il en est de même à chaque impulsion du signal S₂.

Dans cet exemple, les fréquences F₁ et F₂ sont tout d'abord constantes, le contenu du registre ne varie donc pas.

Puis la fréquence F₂ entre les deux dernières impulsions représentées du signal S₂ étant plus petite, le contenu du registre, à la dernière impulsion du signal S₂ est donc plus grand (1101) qu'aux impulsions précédentes du signal S₂ (1100). Le registre tampon charge donc la nouvelle valeur 1101.

La figure 2a représente un registre binaire 1 à n bistables (B₁, B₂, ... Bₙ) utilisé de façon conforme à l'invention associé à des dispositifs d'affichage 10 permettant d'engendrer un signal analogique proportionnel au logarithme du contenu du registre. Chaque bistable Bᵢ est connecté à un dispositif d'affichage Dᵢ avec i entier tel que 1 ≤ i ≤ n.

Un dispositif d'affichage Dᵢ comprend une porte logique OU, 11, connectée à la sortie du bistable Bᵢ et à la sortie de la porte logique OU connectée au bistable B₁₊₁ Chaque porte logique OU, 11 est connectée en sortie à une cellule d'affichage 15 généralement par une résistance de charge 13. La cellule d'affichage est notamment une cellule à cristal liquide ou une diode photo-émissive comme dans l'exemple de la figure.

Il est également possible de réaliser à partir de ces dispositifs d'affichage un générateur de tension ou de courant, de valeur proportionnelle au logarithme du contenu du registre 1, en supprimant les cellules d'affichage 15 et en reliant l'ensemble des résistances de charge 13 à l'entrée d'un amplificateur opérationnel avec une chaîne de contre-réaction résistive, réalisant ainsi un circuit sommateur.

Pour un affichage analogique lumineux du logarithme du contenu du registre, suivant l'origine de l'affichage désiré, on relie le point commun de l'ensemble des cellules d'affichage, assemblées sous forme d'une rampe, soit au niveau de tension d'alimentation positif, soit au niveau de tension d'alimentation négatif (cathodes communes ou anodes communes).

Dans le cas où le niveau de tension commun est positif, l'origine de l'affichage correspond au dispositif d'affichage Dₙ associé au bistable Bₙ de poids le plus fort. Lorsque le niveau de tension commun est négatif ou correspond à une masse comme dans l'exemple de la figure, l'origine de l'affichage correspond au dispositif d'affichage D₁ associé au bistable B₁ de poids le plus faible.

Dans l'exemple de la figure on a représenté le bistable B₁ de poids le plus faible en haut de la figure, l'origine de l'affichage est donc également en haut. On aurait pu tout aussi bien connecter le registre 1 et les dispositifs d'affichage de façon inverse pour avoir le bistable B₁ de poids le plus faible en bas de la figure ainsi que l'origine de l'affichage.

Avec un tel montage, par l'intermédiaire des portes logiques OU connectées les unes aux autres, le bistable activé de poids le plus grand, allume non seulement la cellule d'affichage 15 qui lui est associée mais également l'ensemble des cellules d'affichage associées aux bistables de poids inférieurs.

Ainsi, si le contenu du registre est égal à 10110, le bistable de poids le plus fort activé B₅ va commander l'affichage de l'ensemble des cellules d'affichage associées aux bistables B₄, B₃, B₂ et B₁ quel que soit leur état. En revanche, les cellules d'affichage associées aux bistables B₆, B₇, ... Bₙ resteront éteintes.

Le rang du bistable activé de poids le plus fort représente comme on l'a vu précédemment le logarithme en base deux par excès du contenu du registre. Dans l'exemple cité, le rang du bistable B₅ correspond au nombre entier cinq, celui-ci représente donc le logarithme en base deux par excès du nombre binaire 10110, qui vaut 4,4594.

A cause des fluctuations du contenu du registre, on peut intercaler entre les dispositifs d'affichage et le registre 1 à n bistables un registre tampon 7. Ce dernier est alors utilisé de la même façon que décrit dans la figure 1a, chaque cellule $T_i$ du registre tampon 7 étant connectée en outre en sortie à l'entrée d'une porte logique OU, 11, du dispositif d'affichage $D_i$ correspondant.

Les dispositifs d'affichage 10 décrits ci-dessus permettent d'afficher de façon analogique le logarithme en base deux du contenu du registre par excès ou par défaut par exemple lorsque l'on décale l'origine de l'affichage d'un bistable. Pour augmenter la précision de l'affichage, il faut tenir compte de l'état des bistables de poids inférieurs au bistable de poids le plus fort activé.

La figure 2b représente justement des dispositifs d'affichage permettant d'améliorer la précision de l'affichage analogique du logarithme en base deux du contenu du registre 1 à n bistables. Pour obtenir une précision de $1/(2^P)$ sur l'affichage, on utilise entre un dispositif d'affichage $D_i$ associé au bistable $B_i$ et un dispositif d'affichage $D_{i+1}$ associé au bistable $B_{i+1}$, $2^P-1$ dispositifs d'affichage intermédiaires 25 avec i et p entiers tels que $1 \leq i \leq n$ et $p \geq 1$.

Ainsi, p dispositifs d'affichage intermédiaires sont connectés respectivement par l'intermédiaire d'une porte logique ET, 21, d'une part à un des p bistables $B_{i-1}$, $B_{i-2}$,... $B_{i-p}$ de poids juste inférieur, et d'autre part au bistable $B_i$. Chacun des autres dispositifs d'affichage intermédiaires est connecté, de façon distincte, par l'intermédiaire d'une porte logique ET, 23, aux sorties des portes logiques ET, 21, de deux des dispositifs d'affichage intermédiaires, les $2^P-1$ dispositifs d'affichage intermédiaires étant disposés dans l'ordre du poids le plus fort au poids le plus faible. Il est bien entendu qu'une précision de $1/(2^P)$ ne peut être appliquée qu'à partir du bistable $B_{p+1}$.

Dans l'exemple de la figure, on a représenté un dispositif à trois dispositifs d'affichage intermédiaires 25 qui permettent d'évaluer le logarithme à 1/4 près, (p=2). Ainsi entre le bistable $B_i$ et le bistable $B_{i+1}$ ces trois dispositifs d'affichage intermédiaires sont connectés, respectivement dans l'ordre du poids le plus faible au poids le plus fort, au bistable $B_i$ et au bistable $B_{i-2}$ par l'intermédiaire d'une porte logique ET, 21, au bistable $B_i$ et au bistable $B_{i-1}$ par l'intermédiaire d'une deuxième porte logique ET, 21, et enfin aux sorties des deux portes logiques ET, 21, précédentes, par l'intermédiaire d'une troisième porte logique ET, 23. Ceci permet d'afficher successivement $B_i$, $B_i+B_{i-2}$, $B_i+B_{i-1}$, $B_i+B_{i-1}+B_{i-2}$.

**Revendications**

1. Procédé d'utilisation d'un registre binaire (1) à n cellules bistables connectées entre elles, avec une entrée décalage, pour déterminer le rapport de deux fréquences F1 et F2, caractérisé en ce qu'on envoie sur une entrée comptage un premier signal impulsionnel $S_1$ de fréquence $F_1$ et sur l'entrée décalage un deuxième signal impulsionnel $S_2$ de fréquence $F_2$, avec $F_1 >> F_2$, le contenu du registre (1) étant en permanence incrémenté d'une unité à chaque impulsion du premier signal $S_1$ et décalé de façon à diviser par deux le contenu du registre à chaque impulsion du deuxième signal $S_2$, le contenu dudit registre étant représentatif du rapport des deux fréquences.

2. Procédé d'utilisation d'un registre binaire à n cellules bistables selon la revendication 1, caractérisé en ce qu'on charge le contenu du registre binaire à n cellules bistables dans un registre tampon (7) à n cellules connecté audit registre binaire (1) à chaque impulsion du deuxième signal $S_2$.

3. Procédé d'utilisation d'un registre binaire à n cellules bistables selon l'une quelconque des revendications 1 et 2, caractérisé en ce qu'on envoie en entrée du registre (1) à n cellules bistables un signal de fréquence de référence et un signal de fréquence inconnue, le contenu du registre (1) permettant de déterminer la fréquence inconnue a partir de la fréquence de référence.

4. Procédé d'utilisation d'un registre binaire à n cellules bistables selon l'une quelconque des revendications 1 à 3, caractérisé en ce qu'on affiche le logarithme en base deux du contenu du registre binaire (1) à n cellules bistables par l'intermédiaire de dispositifs d'affichage (10, 25) connectés au registre binaire (1), chaque cellule bistable activée $B_i$ représentant le nombre $2^{(i-1)}$ en numération décimale, avec i entier tel que $1 \leq i \leq n$.

5. Procédé d'utilisation d'un registre binaire à n cellules bistables selon la revendication 1, pour la détection du passage de ce rapport à une valeur donnée, caractérisé en ce que l'impulsion de détection correspond à l'activation de la cellule bistable matérialisant ladite valeur.

6. Dispositif pour la mise en œuvre du procédé d'utilisation d'un registre binaire à n cellules bistables selon l'une quelconque des revendications 1 à 4, caractérisé en ce qu'il comprend:
   – un registre binaire (1) à n cellules bistables,
   – des dispositifs d'affichage (10, 25) pour afficher le logarithme en base deux du contenu du registre, lesdits dispositifs étant connectés d'une part aux sorties du registre binaire (1) et d'autre part à un niveau de tension commun à l'ensemble de ces dispositifs, chaque dispositif d'affichage (10, 25) comprenant une porte logique OU (11) connectée en sortie à une cellule d'affichage (15), la sortie d'une porte logique OU d'un dispositif d'affichage étant connectée à l'entrée de la porte logique OU du dispositif d'affichage de poids inférieur.

7. Dispositif selon la revendication 6, caractérisé en ce que la cellule d'affichage est une diode photo-émissive.

8. Dispositif selon la revendication 6, caractérisé en ce que la cellule d'affichage est une cellule à cristal liquide.

9. Dispositif selon l'une quelconque des revendications 6 à 8, caractérisé en ce que chaque dispositif d'affichage (10) est connecté à une seule cellule bistable à la fois.

10. Dispositif selon l'une quelconque des revendications 6 à 8, caractérisé en ce que les dispositifs d'affichage (10, 25) comprennent $2^P-1$ dispositifs d'affichage intermédiaires (25) permettant d'avoir une précision de 1/(2P) sur l'affichage, es dispositifs d'affichage intermédiaires étant disposés entre un dispositif d'affichage (10) associé à une cellule bistable $B_i$ et un dispositif d'affichage (10) associé à une cellule bistable $B_{i+1}$, avec i et p entiers tels que $1 \le i \le n$ et $p \ge 1$; les dispositifs d'affichage intermédiaires commandés par des dispositifs logiques réalisant des sommes des contenus des cellules bistables $B_i$, $B_{i-1}$, ..., $B_{i-p}$.

11. Dispositif selon l'une quelconque des revendications 6 à 10, caractérisé en ce qu'il comprend un registre tampon (7) à n cellules, chaque cellule étant connectée à la sortie d'une seule cellule bistable du registre binaire (1).

## Claims

1. Process for the use of a binary register (1) with n interconnected bistable cells, with a shift input, for determining the ratio of two frequencies $F_1$ and $F_2$, characterized in that a first pulse signal $S_1$ of frequency $F_1$ is supplied to a counting input and a second pulse signal $S_2$ of frequency $F_2$ is supplied to a shift input, with $F_1 >> F_2$, the content of the register (1) being permanently incremented by one unit for each pulse of the first signal $S_1$ and shifted so as to divide by two the content of the register for each pulse of the second signal $S_2$, the content of said register representing the ratio of the two frequencies.

2. Process for the use of a binary register with n bistable cells according to claim 1, characterized in that the content of the binary register with n bistable cells is loaded into a buffer register (7) with n cells connected to said binary register (1) for each pulse of the second signal $S_2$.

3. Process for the use of a binary register with n bistable cells according to either of the claims 1 and 2, characterized in that a reference frequency signal and an unknown frequency signal is supplied to the input of the register (1) with n bistable cells, the register (1) content making it possible to determine the unknown frequency on the basis of the reference frequency.

4. Process for the use of a binary register with n bistable cells according to any one of the claims 1 to 3, characterized in that the logarithm to base two of the content of the binary register (1) with n bistable cells is displayed via display means (10, 25) connected to the binary register (1), each activated bistable cell $B_i$ representing the number $2^{(i-1)}$ in decimal notation, with i being an integer such that $1 \le i \le n$.

5. Process for the use of a binary register with n bistable cells according to claim 1 for the detection of the passage of said ratio to a given value, characterized in that the detection pulse corresponds to the activation of the bistable cell materializing said value.

6. Apparatus for performing a use process of a binary register with n bistable cells according to any one of the claims 1 to 4, characterized in that it comprises a binary register (1) with n bistable cells and display means (10, 25) for displaying the logarithm to base two of the register content, said means being connected on the one hand to the outputs of the binary register (1) and on the other to a voltage level common to all said means, each display means (10, 25) comprising a logic OR gate (11) connected by the output to a display cell (15), the output of a logic OR gate of a display means also being connected to the input of the logic OR gate of the lower order display means.

7. Apparatus according to claim 6, characterized in that the display cell is a photoemissive diode.

8. Apparatus according to claim 6, characterized in that the display cell is a liquid crystal cell.

9. Apparatus according to any one of the claims 6 to 8, characterized in that each display means (10) is connected to a single bistable cell at the same time.

10. Apparatus according to any one of the claims 6 to 8, characterized in that the display means (10, 25) comprise $2P-1$ intermediate display means (25) making it possible to have an accuracy of $1/(2P)$ on the display, said intermediate display means being placed between a display means (10) associated with a bistable cell $B_i$ and a display means (10) associated with a bistable cell $B_{i+1}$, with i and p being integers such that $1 \le i \le n$ and $p \ge 1$, the intermediate display means controlled by logic devices producing the sums of the contents of the bistable cells $B_i$, $B_{i-1}$, ..., $B_{i-p}$.

11. Apparatus according to any one of the claims 6 to 10, characterized in that it comprises a buffer register (7) with n cells, each cell being connected to the output of a single bistable cell of the binary register (1).

## Patentansprüche

1. Verfahren zur Verwendung eines binären Registers (1) mit n bistabilen, miteinander verbundenen Zellen mit einem Schieberegistereingang zur Bestimmung des Verhältnisses zweier Frequenzen F1 und F2, dadurch gekennzeichnet, daß man zu einem Zähleingang ein erstes Pulssignal $S_1$ mit der Frequenz $F_1$ und zu dem Schieberegistereingang ein zweites Pulssignal $S_2$ mit der Frequenz $F_2$ schickt, wobei $F_1 >> F_2$, wobei der Inhalt des Registers (1) permanent um eine Einheit bei jedem Puls des ersten Signals $S_1$ inkrementiert wird und so verschoben wird, daß der Inhalt bei jedem Puls des zweiten Signals durch zwei geteilt wird, wobei der Inhalt dieses Registers das Verhältnis der beiden Frequenzen darstellt.

2. Verfahren zur Verwendung eines binären Registers mit n bistabilen Zellen nach Anspruch 1, dadurch gekennzeichnet, daß man den Inhalt des binären Registers mit n bistabilen Zellen bei jedem Puls des zweiten Signals S2 in ein mit dem binären Register (1) verbundenes Pufferregister (7) mit n Zellen lädt.

3. Verfahren zur Verwendung eines binären Registers mit n bistabilen Zellen nach einem der Ansprüche 1 und 2, dadurch gekennzeichnet, daß man zum Eingang des Registers (1) mit n bistabilen Zellen ein Signal mit einer Referenzfrequenz und ein Signal mit unbekannter Frequenz schickt, wobei der Inhalt des Registers (1) erlaubt, die unbekannte Frequenz ausgehend von der Referenzfrequenz zu bestimmen.

4. Verfahren zur Verwendung eines binären Registers mit n bistabilen Zellen nach einem der Ansprüche 1 bis 3, dadurch gekennzeichnet, daß man den Logarithmus zur Basis zwei des Inhalts des binären Registers (1) mit n bistabilen Zellen über mit den binären Register (1) verbundene Anzeigevorrichtung (10, 25) anzeigt, wobei jede aktivierte, bistabile Zelle $B_i$ die Zahl $2^{(i-1)}$ in dezimaler Darstellung darstellt, wobei i eine ganze Zahl mit $1 \leq i \leq n$ ist.

5. Verfahren zur Verwendung eines binären Registers mit n bistabilen Zellen nach Anspruch 1 zur Detektion des Durchgangs dieses Verhältnisses durch einen gegebenen Wert, dadurch gekennzeichnet, daß der Detektionspuls der Aktivierung der bistabilen Zelle entspricht, die diesen Wert markiert.

6. Vorrichtung zum Betreiben des Verfahrens zur Verwendung eines binären Registers mit n bistabilen Zellen nach einem der Ansprüche 1 bis 3, dadurch gekennzeichnet, daß sie aufweist:
— ein binäres Register (1) mit n bistabilen Zellen,
— Anzeigevorrichtungen (10, 25) zum Anzeigen des Logarithmus zur Basis zwei des Inhalts des Registers, wobei diese Vorrichtungen auf der einen Seite mit den Ausgängen des Binärregisters (1) und auf der anderen Seite mit einem gemeinsamen Spannungsniveau der Gesamtheit dieser Vorrichtung verbunden sind, wobei jede Anzeigevorrichtung (10, 25) ein logisches ODER-Gatter (11) umfaßt, daß mit seinem Ausgang mit einer Anzeigezelle (15) verbunden ist, wobei der Ausgang eines logischen ODER-Gatters einer Anzeigevorrichtung mit dem Eingang des logischen ODER-Gatters der Anzeigevorrichtung geringerer Bedeutung verbunden ist.

7. Vorrichtung nach Anspruch 6, dadurch gekennzeichnet, daß die Anzeigezelle eine lichtemittierende Diode ist.

8. Vorrichtung nach Anspruch 6, dadurch gekennzeichnet, daß die Anzeigezelle eine Flüssigkristallzelle ist.

9. Vorrichtung nach einem der Ansprüche 6 bis 8, dadurch gekennzeichnet, daß jede Anzeigevorrichtung (10) zur gleichen Zeit mit einer einzigen bistabilen Zelle verbunden ist.

10. Vorrichtung nach einem der Ansprüche 6 bis 8, dadurch gekennzeichnet, daß die Anzeigevorrichtung (10, 25) $2^P - 1$ Zwischenanzeigevorrichtungen (25) umfaßt, die ermöglichen, eine Genauigkeit von $1/(2^P)$ bei der Anzeige zu haben, wobei diese Zwischenanzeigevorrichtungen zwischen einer Anzeigevorrichtung (10), die mit einer bistabilen Zelle $B_i$ verbunden ist, und einer Anzeigevorrichtung (10), die mit einer bistabilen Zelle $B_{i+1}$ verbunden ist, angeschlossen ist, wobei i und p ganze Zahlen sind mit $1 \leq i \leq n$ und $p \geq 1$; wobei die Zwischenanzeigevorrichtungen von logischen Vorrichtungen gesteuert werden, die Summen der Inhalte der bistabilen Zellen $B_i$, $B_{i+1}$, ..., $B_{i-p}$ ausführen.

11. Verfahren nach einem der Ansprüche 6 bis 10, dadurch gekennzeichnet, daß sie ein Pufferregister (7) mit n Zellen aufweist, wobei jede Zelle mit dem Ausgang einer einzigen bistabilen Zelle des binären Registers (1) verbunden ist.

FIG. 1a

FIG. 1b

EP 0 208 602 B1

FIG. 2a

EP 0 208 602 B1

FIG. 2b